# EUROPEAN PATENT SPECIFICATION

(11) **EP 1 615 336 B1**
(45) Date of publication and mention of the grant of the patent: **12.09.2007**
(21) Application number: 04015808.1
(22) Date of filing: 06.07.2004
(51) Int. Cl.: H03D 7/16, H04B 1/28, H04B 1/10, H03D 3/00

(54) **Radio receiver front-end and a method for suppressing out-of-band interference**
Funkempfänger-Eingangsstufe und Verfahren zur Unterdrückung von Ausserbandstörung
Circuits d'entrée de récepteur radio et procédé pour supprimer l'interférence hors-bande

(43) Date of publication of application: 11.01.2006
(73) Proprietor: TELEFONAKTIEBOLAGET LM ERICSSON (publ), 164 83 Stockholm (SE)
(72) Inventor: Sjöland, Henrik, 246 51 Löddeköpinge (SE)
(74) Representative: Asketorp, Göran

(56) References cited:
- US-A- 5 507 036
- US-A1- 2003 162 521
- CHEUNG V S L ET AL: "A 1-V 10-mw monolithic bluetooth receiver in a 0.35-/spl mu/m cmos process" ESSCIRC '03 - 2003 CONFERENCE ON EUROPEAN SOLID-STATE CIRCUITS, 16 September 2003 (2003-09-16), pages 687-690, XP010677180
- BEFFA F ET AL INSTITUTE OF ELECTRICAL AND ELECTRONICS ENGINEERS: "A 6.5-MW RECEIVER FRONT-END FOR BLUETOOTH IN 0.18-MUM CMOS" 2002 IEEE MTT-S INTERNATIONAL MICROWAVE SYMPOSIUM DIGEST.(IMS 2002). SEATTLE, WA, JUNE 2 - 7, 2002, IEEE MTT-S INTERNATIONAL MICROWAVE SYMPOSIUM, NEW YORK, NY : IEEE, US, vol. VOL. 1 OF 3, 2 June 2002 (2002-06-02), pages 501-504, XP001099538 ISBN: 0-7803-7239-5
- WASSENER H-J: "A Small Package Integrated Two Band Mixer-oscillator SI-IC" CONSUMER ELECTRONICS, 1993. DIGEST OF TECHNICAL PAPERS. ICCE., IEEE 1993 INTERNATIONAL CONFERENCE ON ROSEMONT, IL, USA 8-10 JUNE 1993, NEW YORK, NY, USA,IEEE, US, 8 June 1993 (1993-06-08), pages 106-107, XP010107192 ISBN: 0-7803-0843-3
- DARABI H ET AL: "A 4.5-MW 900-MHZ CMOS RECEIVER FOR WIRELESS PAGING" August 2000 (2000-08), IEEE JOURNAL OF SOLID-STATE CIRCUITS, IEEE INC. NEW YORK, US, PAGE(S) 1085-1096 , XP001075109 ISSN: 0018-9200 *Section IV.B ** figure 8 *
- "LOW COST HBT UPCONVERTERS FOR CDMA TRANSMITTER ICS" November 1996 (1996-11), MICROWAVE JOURNAL, HORIZON HOUSE. DEDHAM, US, PAGE(S) 154,156 , XP000681574 ISSN: 0192-6225 * the whole document *
- PIAZZA F ET AL: "FP 20.1: A 170MHZ RF FRONT-END FOR ERMES PAGER APPLICATIONS" 1 February 1995 (1995-02-01), IEEE INTERNATIONAL SOLID STATE CIRCUITS CONFERENCE, IEEE INC. NEW YORK, US, PAGE(S) 324-325,389 , XP000557658 ISSN: 0193-6530 * the whole document *
- KWAN K W ET AL: "A bipolar IF device for GSM mobile telephone" BIPOLAR/BICMOS CIRCUITS AND TECHNOLOGY MEETING, 1992., PROCEEDINGS OF THE 1992 MINNEAPOLIS, MN, USA 7-8 OCT. 1992, NEW YORK, NY, USA,IEEE, US, 7 October 1992 (1992-10-07), pages 55-58, XP010104589 ISBN: 0-7803-0727-5

## Description

### Technical Field of the Invention

The present invention relates to a quadrature radio receiver front-end for converting an input signal having a first frequency to an output signal having a second frequency. The invention also relates to a method for suppressing out-of-band interference of an input signal to a quadrature radio receiver front-end.

### Description of Related Art

Conventional radio receiver front-end design incorporates conversion of incoming radio frequency (RF) signals to one or more intermediate frequency (IF) signals, the last of which is then converted to base band. The radio receiver front-end may comprise a low noise amplifier (LNA) with a substantial voltage gain. Following the low noise amplifier, one or several mixers is/are provided for converting the input signal to the IF signal(s), which is/are provided at the output of the mixer(s).

The quadrature radio receiver front-end is designed to mix a differential or single-ended input signal with four local oscillator signals having different phase, and provide two output signals, one for I-band and one for Q-band.

The input signal may comprise superimposed out-of-band interference. In radio receiver front-ends known in the art, one or several filters for processing the input signal is/are provided. A pre-filter is provided before the LNA to suppress the out-of-band interference. Additional filters may also be provided for processing the input signal. To make the radio receiver front-end cheap, it may be implemented as part of an integrated circuit of a chip. However, filters are difficult to implement with on-chip design. Thus, the filters must often be implemented off-chip. This is a disadvantage as off-chip components make the radio receiver front-end more expensive, larger and complex. Consequently, in the development towards smaller and less expensive radio receivers most of the off-chip filters have been removed. In today's homodyne receivers, the only off-chip filter remaining is the pre-filter. If also the pre-filter could be removed, substantial costs and space could be saved. This is especially true for multi-band radio receiver front-ends requiring one pre-filter per band. If also multiple antennas are used the impact is even higher.

If the pre-filter is simply removed, strong out-of-band interference could saturate the radio receiver. Also, it would cause intermodulation distortion and compression of the input signal. Different communication standards have different requirements of maximum out-of-band interference. E.g. to fulfil the requirements according to the GSM (Global System for Mobile communication) standard, out-of-band interference up to 0dBm must be handled. A conventional radio receiver front-end does not fulfil this requirement without a pre-filter.

In some radio receiver front-end designs, the pre-filter may be integrated on-chip. However, this solution does not fulfill the maximum out-of-band requirements of different mobile communication standards, such as the GSM or the UMTS (Universal Mobile Telecommunication Standard) standards.

US 5,507,036 discloses an apparatus and a method for cancelling distortion in a direct conversion receiver, such distortion created by the mixing of the desired signal with the output signal of an local oscillator. Subsequent to filtering the mixer output signal, the even mode distortion component is extracted, phase shifted, amplified and recombined with the mixed signal in such manner as to suppress even order distortion.

Cheung et al, "A 1-V 10-mW monolithic Bluetooth receiver in a 0.35-µm CMOS process", Proceedings of the 29th European Solid-State Circuits Conference, pages 687-690, Sept 16-18 2003, discloses a CMOS Bluetooth receiver. A low-noise amplifier (LNA) of the receiver comprises an NMOS transistor, the gate of which is connected to an antenna via a transmission line, an off-chip inductor, a bondwire, and a capacitor. The source and drain terminals are connected to ground and supply, respectively, via on-chip spiral inductors and bondwires. The drain terminal, which is the output terminal of the LNA, is directly connected to the gate terminal of an NMOS transistor of a single-balanced image-reject mixer with active loading.

Beffa et al, "A 6.5-mW receiver front-end for Bluetooth in 0.18µm CMOS", 2002 IEEE MTT-S International Microwave Symposium Digest, June 2-7, 2002, discloses a low-IF receiver front-end for Bluetooth. A preamplifier is connected via an RF-filter to an antenna. The preamplifier comprises an NMOS transistor, the gate of which is connected to the input of the preamplifier via an on-chip spiral inductor. The source of the NMOS transistor is connected to ground via a bond-wire inductor, and the drain is connected via an NMOS cascode transistor to the output terminal of the preamplifier. The preamplifier further has a passive load comprising a resistor in parallel with an inductor. The output of the preamplifier is fed to the gate terminal of an NMOS transistor in a single-balanced mixer.

### Summary of the Invention

It is therefore an object of the invention to provide a radio receiver front-end which is less complex than radio receiver front-ends known in the art, and which may be implemented with on-chip technology. It is also an object of the invention to provide a method for suppressing out-of-band interference in a quadrature radio receiver front-end.

According to a first aspect of the invention, these objects are achieved by a quadrature radio receiver front-end according to claim 1, which neither has an on-chip nor an off-chip pre-filter.

The quadrature radio receiver front-end according to the invention comprises a low noise amplifier, a first and a second mixer, and first and second current to voltage conversion means. An input terminal of the quadrature radio receiver front-end is directly connected to an input terminal of the low noise amplifier. Each mixer is a current mode mixer, as the input signal has not been converted to voltage before mixing. An output terminal of the low noise amplifier is directly connected to the input terminal of each mixer. An output terminal of the first and second mixer is connected to first and second current to voltage conversion means, respectively, whereby out-of-band interference of a signal input to the radio receiver front-end is suppressed.

Each current to voltage conversion means may be a mixer load connected to a respective output terminal of the mixers and signal grounding means, respectively. Each mixer load may be a resistor connected in parallel with a capacitor. The capacitor of each mixer load has a value which is effective for suppressing out-of-band interference of a signal input to the radio receiver front-end when said signal has been mixed. The capacitance of the capacitor of each mixer load may be variable for suppressing out-of-band interference of input signals having different bandwidths.

The quadrature radio receiver front-end according to the invention may also comprise a local oscillator for providing signals for driving the first and second mixers, which may be single or double balanced mixers.

The first and the second mixers may be connected to a quadrature voltage controlled oscillator by means of transformers for providing quadrature local oscillator signals. Supplying the local oscillator signals by means of transformers is an advantage as no low-frequency noise will be introduced to the local oscillator terminals of the mixers.

The local oscillator may comprise quadrature oscillators with LC-tanks. Inductors of the LC-tanks may provide primary windings of the transformers, and inductors connected to local oscillator input terminals of each mixer may provide secondary windings of said transformers. Thus, no additional components are needed for providing the transformers except the inductors for providing the secondary windings.

The capacitor of each LC-tank may be a variable capacitor for adjusting the frequency of the quadrature local oscillator signals.

Alternatively, the oscillator may be provided by a high frequency oscillator and frequency dividers arranged to provide four non-overlapping local oscillator signals having a duty cycle of substantially 25% each.

According to a second aspect of the invention, the objects are achieved by the use of the quadrature radio receiver front-end according to claim 15.

According to a third aspect of the invention, the objects are achieved by a wireless electronic communication apparatus according to claim 16.

According to a fourth aspect of the invention, the objects are achieved by a method for suppressing out-of-band interference in a quadrature radio receiver front-end, and for converting said input signal having a first frequency to an output signal having a second frequency according to claim 19. The method comprises the steps of receiving the input signal at an input terminal at the radio receiver front-end; amplifying the input signal comprising out-of-band interference in a low noise amplifier; mixing the input signal and the out-of-band interference with a signal having a second frequency in a first and second current mode mixer to generate a mixed signal comprising out-of-band interference; and suppressing the out-of-band interference of the mixed signal.

The step of suppressing may comprise supplying the mixed input signal comprising the out-of-band interference to a mixer load, which is connected to a respective output terminal of the mixers and signal grounding means, respectively.

The step of suppressing may comprise suppressing by means of a capacitor of a mixer load, which has a value that is effective for suppressing out-of-band interference of the mixed signal.

The method may comprise adjusting the capacitance of the capacitor, which may be a variable capacitor, of the mixer load for suppressing out-of-band interference of mixed input signals having different bandwidths.

The method may also comprise the steps of generating quadrature local oscillator signals, and supplying said generated quadrature local oscillator signals to the first and second mixers for driving said mixers.

Further, the method may comprise adjusting the capacitance of a capacitor of a quadrature local oscillator connected to the mixers for adjusting the frequency of said quadrature local oscillator signals.

Further embodiments of the invention are defined in the dependent claims.

It is an advantage of the invention that no pre-filter is needed in the quadrature radio receiver front-end. Thus, if said front-end is implemented using on-chip technology, the production cost may be lowered compared to a conventional radio receiver front-end having a pre-filter provided either on- or off-chip. Also, the size and complexity of the radio receiver front-end is reduced compared to conventional radio receiver front ends.

It should be emphasized that the term "comprises/comprising" when used in this specification is taken to specify the presence of stated features, integers, steps or components but does not preclude the presence or addition of one or more other features, integers, steps, components or groups thereof.

### Brief Description of the Drawings

Further objects, features and advantages of the invention will appear from the following detailed description of the invention, reference being made to the accompanying drawings, in which:
Fig. 1 is a front view of a mobile communication apparatus comprising a quadrature radio receiver front-end according to the invention;
Fig. 2 is a block-diagram of the quadrature radio receiver front-end according to the invention;
Fig. 3 is a circuit-diagram of an embodiment of the quadrature radio receiver front-end according to the invention;
Fig. 4 is a circuit-diagram of a first embodiment of a quadrature voltage controlled oscillator for generating low noise local oscillator signals;
Fig. 5 is a block-diagram of a high frequency oscillator connected to frequency dividers for generating low noise local oscillator signals;
Fig. 6 is a circuit-diagram of another embodiment of the quadrature radio receiver front-end according to the invention; and
Fig. 7 is a flow-chart of one embodiment of the method according to the invention.

### Detailed Description of Embodiments

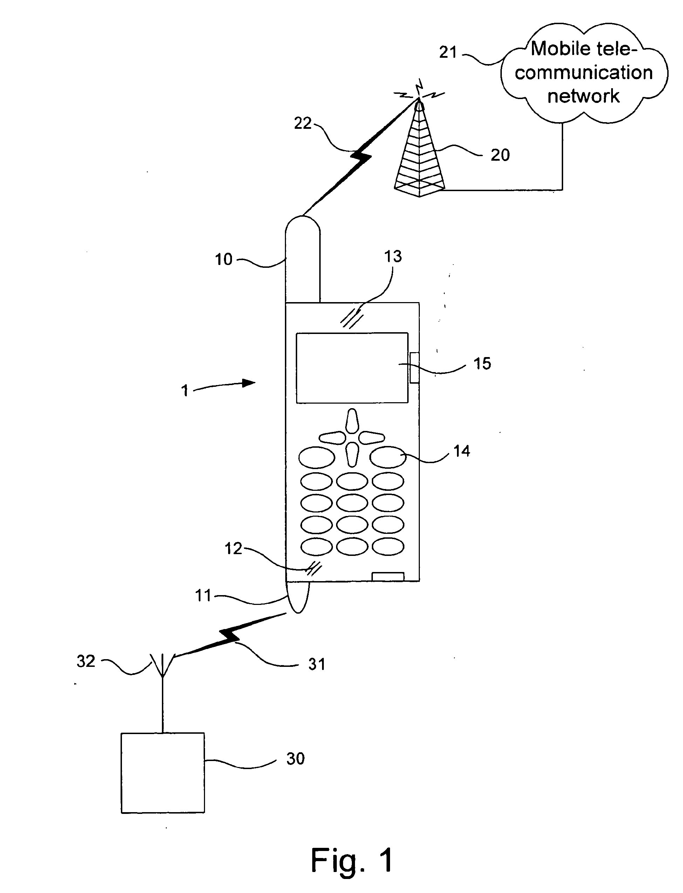

Fig. 1 illustrates a mobile telephone 1 as one exemplifying wireless electronic communication apparatus, in which the quadrature radio receiver front-end according to the present invention may be utilized. The invention is not limited to implementation in a mobile telephone 1. The invention may be implemented in a wide variety of electronic equipment wherein a radio receiver front-end is required for receiving and processing radio frequency (RF) input signals, such as a mobile radio terminal, a pager, a communicator, an electronic organizer or a smartphone. The mobile telephone 1 may comprise a first antenna 10 and a second auxiliary antenna 11 for receiving input signals. A microphone 12, a loudspeaker 13, a keypad 14, and a display 15 provide a man-machine interface for operating the mobile telephone 1.

The mobile telephone may in operation be connected to a radio station 20 (base station) of a mobile communication network 21, such as a GSM, UMTS, PCS (Personal Communications System), and/or PDC (Personal Digital Cellular), via a first radio link 22 by means of the first antenna 10. Furthermore, the mobile telephone 1 may in operation establish a second wireless link to a peripheral device 30 via a second radio link 31 by means of the auxiliary antenna 11. The second radiolink 31 is e.g. a Bluetooth^{®} link, which is established in the 2.4 (2.400-2.4835) GHz frequency range. To establish the radio links 22, 31, the mobile telephone 1 comprises radio resources, which are adapted according to the relevant technologies that are used. Thus, the mobile telephone 1 comprises a first radio access means, such as a transceiver, for communicating radio signals with the base station 20, and a second radio access means for communicating radio signals with the peripheral device 30. Alternatively, one radio access means may be switchable to communicate radio signals with either the base station 20 or the peripheral device 30.

The peripheral device 30 may be any device having wireless communicating capabilities, such as according to Bluetooth^{®} technology or any other wireless local area network (WLAN) technology. It comprises an antenna 32 for exchanging signals over the second link 31, and a transceiver (not shown) adapted according to the communication technology that the peripheral device 30 uses. The device may be a wireless headset, a remote server, a fax machine, a vending machine, a printer, a computer etc. A wide variety of electronic equipment may have such communication capabilities and have a need for wirelessly transferring data.

When receiving input signals having radio frequencies (RF), the RF signals are processed by the radio receiver front-end according to the invention. The input signals may be single-ended or differential. The input signal is converted to intermediate frequency (IF) signals before further signal processing is applied. Thus, the radio receiver front-end of the mobile telephone 1 may comprise one or several mixers for converting a signal having a first frequency to signals having a second frequency as will be disclosed in the following.

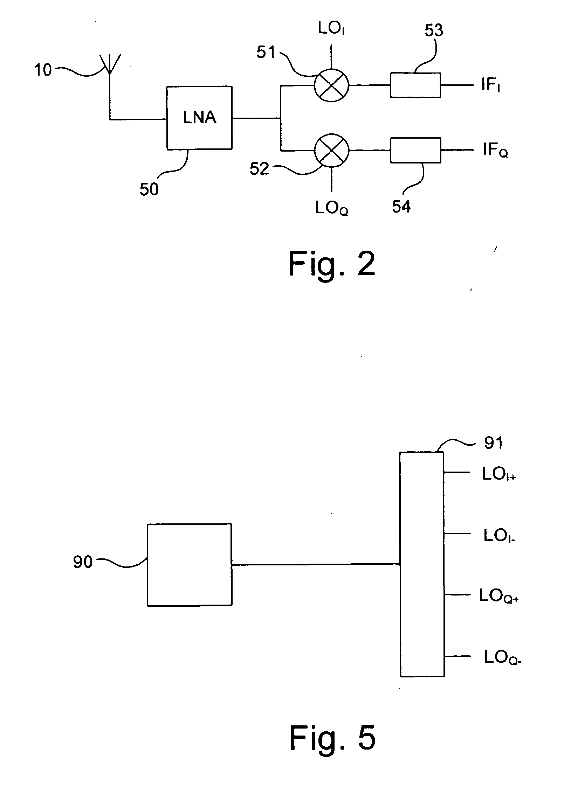

Fig. 2 illustrates the radio receiver front-end according to the invention. The antenna 10 is connected to an input terminal of a low noise amplifier (LNA) 50. The LNA 50 is inherently linear or linearized, such that it can handle out-of band interference, e.g. according to the GSM standard, wherein out-of-band interference up to at least 0 dBm should be handled. The RF signal input to the LNA 50 comprises both the desired signal and superimposed out-of-band interference, which are amplified by the gain of the LNA 50.

Input terminals of a first and a second mixer 51, 52 are connected to an output terminal of the LNA 50. The first mixer 51 is used for the I-channel of the input signal and the second mixer 52 is used for the Q-channel of the input signal. The output terminal of the LNA 50 is directly connected to the input terminals of the mixers 51, 52, i.e. the signal current from the LNA 50 is not converted to a voltage by a load impedance. With a 0 dBm interferer, a signal converted to a voltage would be too large to handle. Each mixer also comprises local oscillator (LO) input terminals for receiving LO signals, which are generated by an LO signal generating means, to be mixed with the amplified input signal. The first mixer 51 is adapted to receive a first LO signal LO_{I}, to which it is responsive. The second mixer 52 is adapted to receive and be responsive to a second LO signal LO_{Q} having a second phase, which is different from the first phase.

Output terminals of the first and the second mixer 51, 52 are connected to first and second current to voltage conversion means 53, 54, respectively. Thus, the input signal, which now is amplified and mixed to lower frequency signals, is converted to voltage, wherein I- and Q-channel output signals IF_{I}, IF_{Q} are provided at output terminals of the current to voltage conversion means 53, 54, respectively. The current to voltage conversion means 53, 54 will also function as a suppression means for suppressing the out-of-band interference.

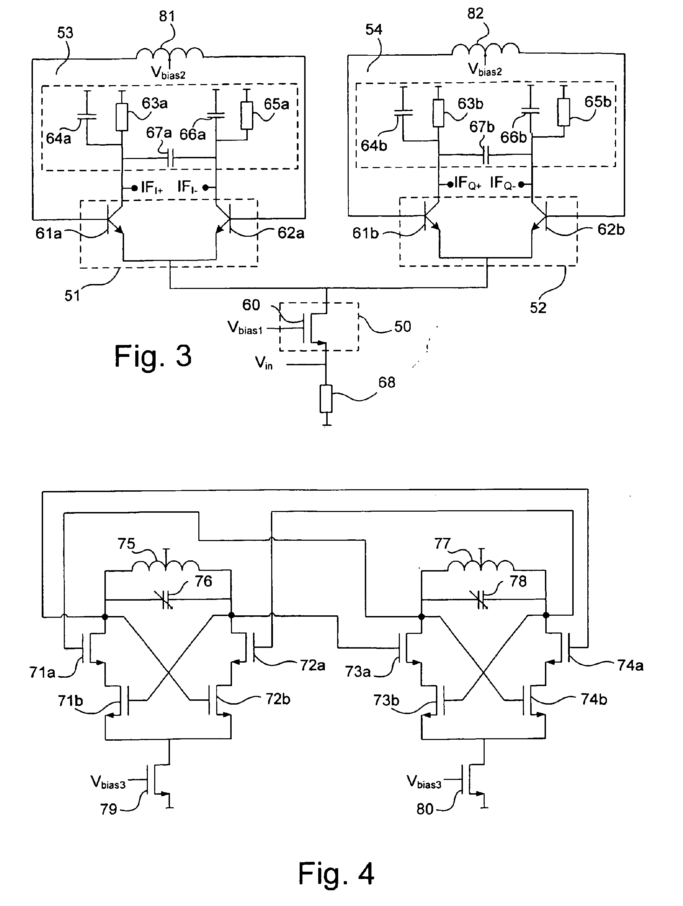

Fig. 3 is a circuit-diagram of one embodiment of the quadrature radio receiver front-end according to the invention. With the design according to the invention it is of importance that the linearity of the LNA is sufficiently high to handle out-of-band interference of e.g. up to 0 dBm, as described above. In the embodiment of Fig. 3, the LNA is a common gate or common base LNA provided by an amplifier transistor 60. The transistor 60 may be an FET (Field Effect Transistor), such as an MOS (Metal Oxide Semiconductor) transistor or a BJT (Bipolar Junction Transistor) transistor. In the embodiment of Fig. 3, the LNA 50 is provided by an FET transistor. The input terminal of the quadrature radio receiver front-end is connected to the source terminal of the transistor 60.

The gate of amplifier transistor 60 is connected to a bias voltage V_{bias1}. Alternatively, a bias input (gate) of the amplifier transistor 60 is connected to a common mode feedback circuit for controlling the bias of said amplifier transistor 60.

As the mixers 51, 52 and the first and second current to voltage conversion means 53, 54 have similar design, only the first mixer 51 and the associated first current to voltage conversion means 53 will be described in detail in the following. The first mixer 51 may comprise first and second mixer transistors 61a, 62a connected to the input terminal of the first mixer 51. The mixer transistors 61a, 62a may be FET transistors or BJT transistors. It is an advantage of the BJT transistor that it is quicker than the FET transistor, which provides a higher linearity. In the embodiment of Fig. 3, the mixer transistors 61a, 62a are provided by BJT transistors. The emitter of each mixer transistor 61a, 62a is connected to the input terminal of the first mixer 51. The base of the mixer transistors are connected to LO (Local Oscillator) input terminals of the first mixer 51. Each mixer transistor 61a, 62a is responsive to a different quadrature LO signal. The first mixer transistor 61a is responsive to a first quadrature LO signal LO_{I+} having a first phase. The second mixer transistor 62a is responsive to a second LO signal LO_{I-}having a second phase, which is offset by 180° with regard to the first phase. The collectors of the mixer transistors 61a, 62a are connected to first and second output terminals of the first mixer 51.

A capacitor 67a is provided between the input terminals of the current to voltage conversion means for filtering of out-of-band interference and to provide some channel filtering.

The mixers 51, 52 are current mode mixers operating in the current domain. The output signals from the first mixer 51 are converted to voltage by the first current to voltage conversion means 53. The first current to voltage conversion means 53 may comprise separate conversion means for each output signal, each conversion means comprising a resistor 63a, 65a and a capacitor 64a, 66a connected in parallel to the output terminals of the first mixer 51 and signal grounding means, such as supply voltage. The first mixer transistor 61a is connected to resistor 63a and capacitor 64a, and the second mixer transistor 62a is connected to resistor 65a and capacitor 66a.

A first IF (Intermediate Frequency) output signal IF_{I} for the I-band may be generated between the output terminals of the first mixer 51. The desired signal, which may be centered at low frequencies, is not significantly attenuated by the capacitors 64a, 66a and 67a. The out-of-band interference, however, which in GSM will occur at a frequency of at least 20 MHz offset from the desired signal, may be heavily attenuated by choosing a suitable value of capacitors 64a, 66a and 67a. Furthermore, LO to IF leakage is suppressed by capacitor 64a, 66a and 67a, enabling the use of single balanced mixers and a single-ended LNA. A single ended LNA removes the need of an external balun. An external filter may perform the balun function. Thus, if a differential LNA is utilized, a stand alone external balun may need to be provided. The signals after the radio receiver front-end are differential, which is suitable for further processing on-chip.

The LNA 50 may alternatively be provided by a feedback LNA, which is sufficiently linear for handling out-of-band interference of up to 0 dBm for satisfying the GSM standard. However, the linearity requirement has to be considered in each specific case.

The second mixer 52 comprises first and second mixer transistors 61b, 62b, and is configured as the first mixer 51. The second current to voltage conversion means 54 comprises a mixer load provided by resistors 63b, 65b and capacitors 64a, 66b, and a capacitor 67b arranged between the input terminals of the second current to voltage conversion means 54. The first mixer transistor 61b of the second mixer 52 is responsive to a third quadrature LO signal LO_{Q+} having a third phase offset by 90° with regard to the first phase. The second mixer transistor 62b of the second mixer 52 is responsive to a fourth LO signal LO_{Q-}having a fourth phase, which is offset by 270° with regard to the first phase. The collectors of the mixer transistors 61b, 62b of the second mixer 52 are connected to first and second output terminals of the second mixer 52.

A second IF (Intermediate Frequency) output signal IF_{Q} for the Q-band may be generated between the output terminals of the second mixer 52.

To provide bias current to the radio receiver front-end, a current device 68 is connected to the input terminal of the radio receiver front-end and the input terminal of the LNA 50. The current device 68 may e.g. be provided by a resistor, an inductor, a transistor connected as a current source. An inductor has the advantage that it causes a lower voltage drop than a resistor or transistor connected as a current source. Also, if current device 68 is provided by an inductor it can tune out parasitic capacitance appearing at the source of transistor 60.

The LO input terminals of the first and second mixers 51, 52 are connected to a quadrature LO signal generating means. Since the signal to out-of band interference ratio is not improved by filtering before the mixers, the phase-noise of the LO signals must be very low at offset frequencies, e.g. above 20 MHz in a GSM implementation. If the phase-noise is too high, reciprocal mixing of strong out-of-band interference can block the reception of weak signals. In the GSM case, the requirement of the phase-noise will be similar to what is needed in a transmitter. Thus, the same or a similar oscillator may be used for generating the LO signals LO_{I+}, LO_{I-}, LO_{Q+}, LO_{Q-} for the transmitter and the radio receiver front-end. The low-frequency local oscillator noise must also be low, since it is directly transferred to the IF outputs.

Fig. 4 illustrates one embodiment of a quadrature VCO (Voltage Controlled Oscillator). A possibility to generate low phase-noise quadrature signals substantially free from low-frequency noise is to use quadrature oscillators with LC-tanks. The LC-tanks may be part of transformers having secondary windings connected to the mixers 51, 52. No local oscillator buffers are needed in this case, and the DC-level of the local oscillator signal fed to the mixers may easily be set. The quadrature VCO comprises four pairs of transistors 71a, 71b, 72a, 72b, 73a, 73b, 74a, 74b. Said transistors may be provided by FET or BJT transistors.

The source of transistor 71a is connected to the drain of transistor 71b. The gate of transistor 71a is connected to the drain of transistor 73a, and the drain of transistor 71a is connected to a first LC-tank comprising an inductor 75 connected in parallel with a capacitor 76. The center tap of inductor 75 is connected to the supply voltage. The value of capacitor 76 will set the frequency of the quadrature VCO. The gate of transistor 71b is connected to the drain of transistor 72a and to the gate of transistor 73a. The source of transistor 71b is connected to the drain of a bias transistor 79. The gate of bias transistor 79 will in operation receive a bias voltage V_{bias3}. The source of bias transistor 79 is connected to grounding means.

The drain of transistor 72a is connected to second terminals of inductor 75 and capacitor 76, and to the gate of transistor 73a and 71b. The gate of transistor 72a is connected to the drain of transistor 74a. The source of transistor 72a is connected to the drain of transistor 72b. The gate of transistor 72b is connected to the drain of transistor 71a and to the gate of transistor 74a. The source of transistor 72b is connected to the drain of bias transistor 79.

The source of transistor 73a is connected to the drain of transistor 73b. The gate of transistor 73a is connected to the drain of transistor 72a, and the drain of transistor 73a is connected to a second LC-tank comprising an inductor 77 connected in parallel with a capacitor 78, and to the gate of transistor 71a. The center tap of inductor 77 is connected to the supply voltage. The value of capacitor 78 should track that of capacitor 76 and it will set the frequency of the quadrature VCO. The gate of transistor 73b is connected to the drain of transistor 74a and to the gate of transistor 72a. The source of transistor 73b is connected to the drain of a bias transistor 80. The gate of bias transistor 79 will in operation receive the bias voltage V_{bias3}. The source of bias transistor 80 is connected to grounding means.

The drain of transistor 74a is connected to second terminals of inductor 77 and capacitor 78, and to the gate of transistor 72a and 73b. The gate of transistor 74a is connected to the drain of transistor 71a. The source of transistor 74a is connected to the drain of transistor 74b. The gate of transistor 74b is connected to the gate of transistor 71a and to the drain of transistor 73a. The source of transistor 74b is connected to the drain of bias transistor 80.

The quadrature VCO is magnetically coupled to the LO input terminals of the mixers 51, 52 by means of first and second transformers. The first transformer comprises the inductor 75 and an inductor 81 connected to the gate of transistor 61a and the gate of transistor 62a. The primary winding of the first transformer is provided by inductor 75, and the secondary winding thereof is provided by inductor 81. Similarly, the second transformer comprises the inductor 77 and an inductor 82 connected to the gate of transistor 61b and to the gate of transistor 62b.

Supplying the LO signals LO_{I+}, LO_{I-}, LO_{Q+}, LO_{Q-} to the mixer transistors 61a, 61b, 62a, 62b through the transformers entails that no low-frequency noise will be applied to the LO input terminals of the mixers 51, 52. Inductor 81 and 82 will short out any low-frequency noise at the LO input terminals. Furthermore, the transformer will not consume any current, as it only comprises passive components, which is an advantage if low power consumption is of importance.

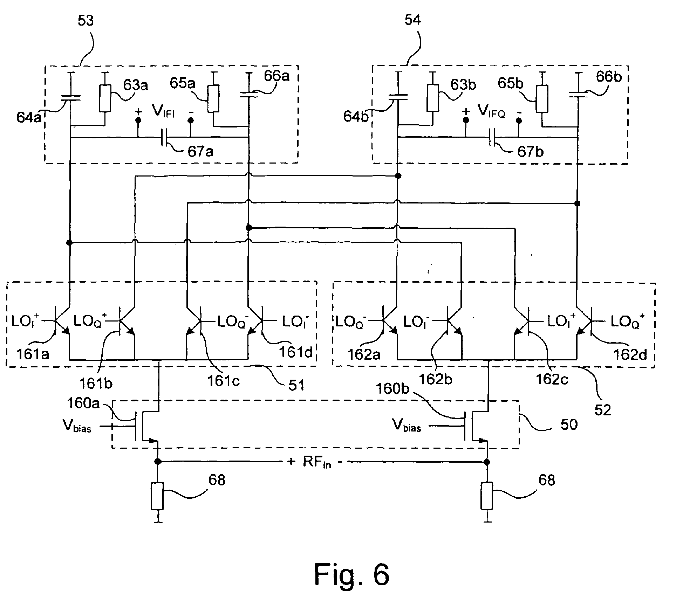

Fig. 5 illustrates an alternative solution for generating the LO signals LO_{I+}, LO_{I-}, LO_{Q+}, LO_{Q-} with sufficiently low phase-noise and low-frequency noise. A high frequency oscillator 90 is connected to four digital frequency divider 91, which will generate the four LO signals LO_{I+}, LO_{I-}, LO_{Q+}, LO_{Q-}, of which only one is active at a time. The frequency of the high frequency oscillator should at least be twice the frequency of the output signals from the digital frequency divider 91. It is important to avoid time overlaps when more than one of the four local oscillator signals are simultaneously high. The overlaps can be avoided by arranging the frequency divider 91to provide an approximate duty cycle of 25% for each of the output signals. If overlaps exist, additional noise is generated and the sensitivity to matching inaccuracy of the mixer transistors is increased. However, if the noise requirement is less strict some overlap may be allowed. It is an advantage of the VCO and the digital frequency divider 91 that they provide a more compact design, albeit with increased current consumption compared to the quadrature VCO implementation described above.

The frequency dividers 91, 92, 93, 94 may be provided by a Johnson counter with four flip-flops in series; where the output signal of the last flip-flop is fed back to the input terminal of the first one. All flip-flops should be clocked by the same clock signal of four times the frequency of the output signal. The flip-flops have to be forced to a state where only one output is high at the time to avoid loops of false states. The four LO signals can then be extracted at the outputs of the four flip-flops.

In the above description, the input signal Vᵢₙ is single ended. However, the input signal may equally be differential, wherein the LNA 50 will be arranged to amplify the differential signal, which then is supplied to double balanced mixers instead of a single balanced mixer as described above.

The radio receiver front-end as described above may be adapted to dual mode mobile communication, wherein it may handle incoming signals from at least two mobile communication networks applying different communication standards, such as GSM and UMTS. A dual mode radio receiver front-end may be provided by arranging two radio receiver front-end circuits as disclosed above in parallel, wherein each front-end is adapted according to a specific standard. The parallel-connected circuits may be selectively activated by biasing the LNA of each radio receiver front-end circuit selectively. A controller may be arranged to control the biasing of the LNAs.

Alternatively, a dual mode radio receiver front-end may be provided by changing the bandwidth of the current to voltage conversion means 53, 54. Thus, if the capacitors 64a, 64b, and 67a are variable capacitors having selectively variable capacitance values, a controller may be arranged to set specific values of the capacitors 64a, 64b, and 67a. The value set will be chosen such that out-of-band interference of input signals of different received signal bandwidths will be suppressed and the signal to be received is essentially unaffected.

According to the invention a topology for making the LNA and the mixer arrangement sufficiently linear for handling out-of-band interference is chosen. If the LNA and the mixer arrangement were not sufficiently linear, the out-of-band interference would cause intermodulation distortion and compression of the input signal as the pre-filter is removed according to the invention.

Fig. 6 is a circuit-diagram of another embodiment of the quadrature radio receiver front-end according to the invention. Components that correspond to components of the embodiment Fig. 3 are denoted by the same reference numerals and will not be described in relation to the embodiment of Fig. 6. However, even if the components correspond, it should be noted that the values thereof may differ depending on the actual implementation.

The radio receiver front-end illustrated in Fig. 6 comprises a double balanced mixer with a differential LNA. The differential amplifier comprises a first and a second amplifier means, e.g. provided by a first and a second amplifier transistor 160a, 160b, such as a MOS or BJT transistor. The input terminals of the quadrature radio receiver front end is connected to the source terminals of transistors 160a, 160b, to which an input signal RFᵢₙ may be applied.

The gates of transistors 160a and 160b are connected to a bias voltage V_{bias}. Alternatively, the bias input (gate) of transistors 160a and 160b are connected to a common mode feedback circuit for controlling the bias of said transistors 160a, 160b.

The first and the second mixer 51, 52 each comprise four mixer transistors 161a, 161b, 161c, 161d, 162a, 162b, 162c, 162d. The gate of transistors 161a and 162c are connected to receive the local oscillator signal LO_{I}⁺. The gate of transistors 161b and 162d are connected to receive the local oscillator signal LO_{Q}⁺. The gate of transistors 161c and 162a are connected to receive the local oscillator signal LO_{Q}⁻. The gate of transistors 161d and 162b are connected to receive the local oscillator signal LO_{I}⁻.

The drain of transistors 161a and 162b are connected to a first terminal of capacitor 64a, resistor 63a and capacitor 67a. The drain of transistors 161b and 162a are connected to a first terminal of capacitor 64b, resistor 63b and capacitor 67b. The drain of transistors 161c and 162d are connected to a first terminal of capacitor 66b and resistor 65b and to a second terminal of capacitor 67b. The drain of transistors 161d and 162c are connected a first terminal of capacitor 66a and resistor 65a, and to a second terminal of capacitor 67a.

The first output signal V_{IFI} will during operation be generated between output terminals connected to the terminals of capacitor 67a, and the second output signal V_{IFQ} will be generated between output terminals connected to the terminals of capacitor 67b.

The local oscillator signals LO_{I}⁺, LO_{I}⁻, LO_{Q}⁺, LO_{Q}⁻ may be provided according to the principles as described above.

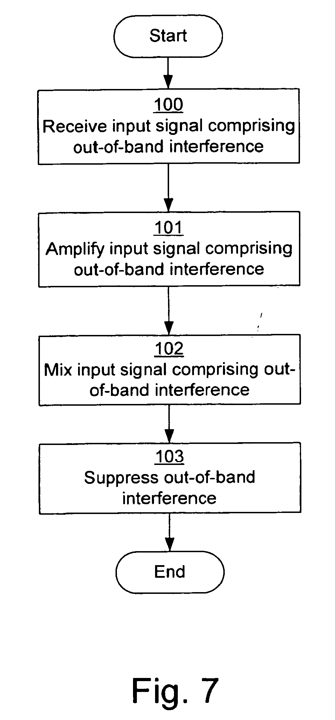

Fig. 7 illustrates the method according to the invention. In a first step 100, the input signal, which comprises out-of-band interference, is received at the input terminal of the quadrature radio receiver front-end. In step 101, the input signal comprising the out-of-band interference is amplified in the LNA 50. Then, in step 102, the amplified input signal and the out-of-band interference is mixed with the LO signals, as discussed above, to generate a mixed signal comprising out-of-band interference. Finally, in step 103 the out-of-band interference of the mixed signal is suppressed, e.g. as discussed above by supplying the mixed signal to the mixer loads comprising resistors and capacitors. The capacitors 64a, 66a, 64b, 66b, 67a, 67b of the mixer loads have values that are effective for suppressing the out-of-band interference. If said capacitors are variable capacitors, the method may comprise the step of setting the value of said capacitors. The method may also comprise the step of supplying the LO signals to the mixers, 51, 52. Furthermore, if the capacitors 76, 78 of the LC-tanks of the quadrature VCO are variable, the method may comprise the step of setting the value of said capacitors.

The present invention has been described above with reference to specific embodiments. However, other embodiments than the above described are equally possible within the scope of the invention. The different features of the invention may be combined in other combinations than those described. The invention is only limited by the appended patent claims.

## Claims

1. A quadrature radio receiver front-end for converting an input signal having a first frequency to an output signal having a second frequency, the quadrature radio receiver front-end comprising an input terminal, a low noise amplifier (50) having an input terminal and an output terminal, a first and a second mixer (51, 52) each having an input terminal and an output terminal, and first and second current to voltage conversion means (53, 54); wherein
the input terminal of the quadrature radio receiver front-end is directly connected to the input terminal of the low noise amplifier (50);
each mixer (51, 52) is a current mode mixer;
the output terminal of the first and second mixer is connected to the first and the second current to voltage conversion means (53, 54), respectively; and
each current to voltage conversion means (53, 54) is a mixer load connected to a respective output terminal of the mixers and signal grounding means;
**characterized in that**
the low-noise amplifier (50) comprises at least one transistor (60) connected in a common gate or a common base configuration,
the output terminal of the low noise amplifier is directly connected to the input terminal of each mixer; and
each mixer load is a resistor (63a, 65a, 63b, 65b) connected in parallel with a capacitor (64a, 66a, 64b, 66b), and wherein a capacitor (67a, 67b) is connected between the output terminals of each mixer.

2. The quadrature radio receiver according to claim 1, wherein the capacitors (64a, 66a, 64b, 66b, 67a, 67b) of each mixer load has a value which is effective for suppressing out-of-band interference of a signal input to the radio receiver front-end when said signal has been mixed.

3. The quadrature radio receiver front-end according to claim 2, wherein the capacitance of the capacitors (64a, 66a, 64b, 66b, 67a, 67b) of each mixer load is variable for suppressing out-of-band interference of input signals of different received signal bandwidths.

4. The quadrature radio receiver front-end according to any of the previous claims, further comprising a local oscillator for providing signals for driving the first and second mixers (61a, 62a, 61b, 62b), said mixers being single-balanced mixers.

5. The quadrature radio receiver front-end according to claim 4, wherein each mixer (51, 52) comprises a first and a second transistor (61a, 62a, 61b, 62b), each transistor being responsive to a different quadrature local oscillator signal.

6. The quadrature radio receiver front-end according to any of the claims 1 to 3, further comprising a local oscillator for providing signals for driving the first and second mixers (161a, 161b, 161c, 161d, 162a, 162b, 162c, 162d), said mixers being double balanced mixers and said low noise amplifier being a differential amplifier (160a, 160b).

7. The quadrature radio receiver front-end according to any of the claims 4 to 6, wherein the first and the second mixer (51, 52) are connected to a quadrature voltage controlled oscillator by means of transformers (75, 77, 81, 82) for providing the quadrature local oscillator signals at local oscillator input terminals of said first and second mixer.

8. The quadrature radio receiver front-end according to claim 7, wherein the voltage controlled oscillator comprises quadrature oscillators (71a, 71b, 72a, 72b, 73a, 73b, 74a, 74b) with LC-tanks, each LC-tank being provided by an inductor (75, 77) and a capacitor (76, 78).

9. The quadrature radio receiver front-end according to claim 8, wherein the inductors (75, 77) of the LC-tanks provide primary windings of the transformers, and wherein the inductors (81, 82) connected to the local oscillator input terminals of each mixer (51, 52, 61a, 62a, 61b, 62b) provide secondary windings of said transformers.

10. The quadrature radio receiver front-end according to claim 8 or 9, wherein the capacitor (76, 78) of each LC-tank is a variable capacitor for adjusting the frequency of the quadrature local oscillator signals.

11. The quadrature radio receiver front-end according to any of the claims 1 to 6, further comprising a high frequency oscillator (90) and frequency dividers (91, 92, 93, 94) for providing the local oscillator signals.

12. The quadrature radio receiver front-end according to claim 11, wherein the frequency dividers (91, 92, 93, 94) are arranged to provide four local oscillator signals having a duty cycle of substantially 25% each, and only one of said local oscillator signals being in the high state at a time.

13. The quadrature radio receiver front-end according to any of the previous claims, further comprising a current device (68) connected to the input terminal of the low noise amplifier and grounding means.

14. The quadrature radio receiver front-end according to claim 13, wherein the current device (68) is an inductor, a resistor, or a transistor connected as a current source.

15. Use of a quadrature radio receiver front-end according to any of the previous claims in a wireless electronic communication apparatus (1) for converting an input signal having a first frequency to a signal having a second frequency.

16. A wireless electronic communication apparatus (1) comprising a quadrature radio receiver front-end according to any of the claims 1-14.

17. The wireless electronic communication apparatus according to claim 16, wherein the wireless electronic communication apparatus (1) is a mobile radio terminal, a pager, a communicator, an electronic organizer or a smartphone.

18. The wireless electronic communication apparatus according to claim 16, wherein the wireless electronic communication apparatus is a mobile telephone (1).

19. A method for suppressing out-of-band interference of an input signal to a quadrature radio receiver front-end, and for converting said input signal having a first frequency to an output signal having a second frequency, the method comprising the step of receiving the input signal at an input terminal of the radio receiver front-end, comprising the steps of
amplifying the input signal comprising out-of-band interference in a low noise amplifier (50); and
mixing the input signal and the out-of-band interference with a signal having a second frequency in a first and second current mode mixer (51, 52) to generate a mixed signal comprising out-of-band interference;
**characterized by**
suppressing the out-of-band interference of the mixed signal by supplying the mixed signal to mixer loads comprising a resistor (63a, 65a, 63b, 65b) connected in parallel with a capacitor (64a, 66a, 64b, 66b) and a capacitor (67a, 67b) connected between the output terminals of each mixer, wherein each mixer load is connected to a respective output terminal of the mixers (51, 52) and signal grounding means; and in that
the low-noise amplifier (50) comprises at least one transistor connected in a common-base or common-gate configuration.

20. The method according to claim 19, wherein the step of suppressing comprises suppressing by means of the capacitors (64a, 66a, 64b, 66b, 67a,67b) of each mixer load, which have values that are effective for suppressing out-of-band interference of the mixed signal.

21. The method according to claim 20, further comprising adjusting the capacitance of the capacitor (64a, 66a, 64b, 66b, 67a, 67b), which is an variable capacitor, of each mixer load for suppressing out-of-band interference of mixed signals of different received signal bandwidths.

22. The method according to any of the claims 19 to 21, further comprising the step of generating quadrature local oscillator signals, and supplying said generated quadrature local oscillator signals to the first and second mixers (51, 52), said mixers being single-balanced mixers, for driving said mixers.

23. The method according to claim 22, further comprising adjusting the capacitance of a capacitor (76, 78) of a quadrature local oscillator connected to the mixers (51, 52) for adjusting the frequency of said quadrature local oscillator signals.

## Patentansprüche

1. Quadratur-Funkempfänger-Eingangsstufe zum Umwandeln eines Eingangssignals mit einer ersten Frequenz in ein Ausgangssignal mit einer zweiten Frequenz, wobei die Quadratur-Funkempfänger-Eingangsstufe einen Eingangsanschluss, einen rauscharmen Verstärker (50) mit einem Eingangsanschluss und einem Ausgangsanschluss, einen ersten und einen zweiten Mischer (51, 52), die jeweils einen Eingangsanschluss und einen Ausgangsanschluss haben, und eine erste und eine zweite Strom-zu-Spannungs-Umwandlungseinrichtung (53, 54) umfasst; wobei
der erste Eingangsanschluss der Quadratur-Funkempfänger-Eingangsstufe direkt mit dem Eingangsanschluss des rauscharmen Verstärkers (50) verbunden ist;
jeder Mischer (51, 52) ein Current-Mode-Mischer ist;
der Ausgangsanschluss des ersten und des zweiten Mischers mit der ersten bzw. der zweiten Strom-zu-Spannungs-Umwandlungseinrichtung (53, 54) verbunden ist; und
jede Strom-zu-Spannungs-Umwandlungseinrichtung (53, 54) eine Mischerlast ist, die mit einem jeweiligen Ausgangsanschluss der Mischer und einer Signalerdungseinrichtung verbunden ist;
**dadurch gekennzeichnet, dass**
der rauscharme Verstärker (50) wenigstens einen Transistor (60) umfasst, der in einer Gate-Schaltungs- oder einer Basisschaltungs-Konfiguration verbunden ist,
der Ausgangsanschluss des rauscharmen Verstärkers direkt mit dem Eingangsanschluss jedes Mischers verbunden ist; und
jede Mischerlast ein Widerstand (63a, 65a, 63b, 65b) ist, der parallel mit einem Kondensator (64a, 66a, 64b, 66b) geschaltet ist, und wobei ein Kondensator (67a, 67b) zwischen die Ausgangsanschlüsse jedes Mischers geschaltet ist.

2. Quadratur-Funkempfänger-Eingangsstufe gemäß Anspruch 1, wobei die Kondensatoren (64a, 66a, 64b, 66b, 67a, 67b) jeder Mischerlast einen Wert haben, der wirksam ist zum Unterdrücken einer Außerband-Interferenz eines an die Funkempfänger-Eingangsstufe eingegebenen Signals, wenn das Signal gemischt worden ist.

3. Quadratur-Funkempfänger-Eingangsstufe gemäß Anspruch 2, wobei die Kapazität der Kondensatoren (64a, 66a, 64b, 66b, 67a, 67b) jeder Mischerlast variabel ist zum Unterdrücken der Außerband-Interferenz von Eingangssignalen unterschiedlicher empfangener Signalbandbreiten.

4. Quadratur-Funkempfänger-Eingangsstufe gemäß einem der vorhergehenden Ansprüche, mit ferner einem Lokaloszillator zum Bereitstellen von Signalen zum Treiben des ersten und des zweiten Mischers (61a, 62a, 61b, 62b), wobei die Mischer einfach symmetrische Mischer sind.

5. Quadratur-Funkempfänger-Eingangsstufe gemäß Anspruch 4, wobei jeder Mischer (51, 52) einen ersten und einen zweiten Transistor (61a, 62a, 61b, 62b) umfasst, wobei jeder Transistor auf ein unterschiedliches Quadratur-Lokaloszillator-Signal anspricht.

6. Quadratur-Funkempfänger-Eingangsstufe gemäß einem der Ansprüche 1 bis 3, ferner mit einem Lokaloszillator zum Bereitstellen von Signalen zum Treiben des ersten und des zweiten Mischers (161a, 161b, 161c, 161d, 162a, 162b, 162c, 162d), wobei die Mischer doppelt symmetrische Mischer sind und der rauscharme Verstärker ein Differenzialverstärker (160a, 160b) ist.

7. Quadratur-Funkempfänger-Eingangsstufe gemäß einem der Ansprüche 4 bis 6, wobei der erste und der zweite Mischer (51, 52) mit einem quadraturspannungsgesteuerten Oszillator mittels eines Transformators (75, 77, 81, 82) zum Bereitstellen der Quadratur-Lokaloszillator-Signale bei Lokaloszillator-Eingangsanschlüssen des ersten und des zweiten Mischers verbunden sind.

8. Quadratur-Funkempfänger-Eingangsstufe gemäß Anspruch 7, wobei der spannungsgesteuerte Oszillator Quadraturoszillatoren (71a, 71b, 72a, 72b, 73a, 73b, 74a, 74b) mit LC-Speichern umfasst, wobei jeder LC-Speicher durch einen Induktor (75, 77) und einen Kondensator (76, 78) bereitgestellt ist.

9. Quadratur-Funkempfänger-Eingangsstufe gemäß Anspruch 8, wobei die Induktoren (75, 77) der LC-Speicher Primärwicklungen der Transformatoren bereitstellen, und wobei die mit den Lokaloszillator-Eingangsanschlüssen jedes Mischers (51, 52, 61a, 62a, 61b, 62b) verbundenen Induktoren (81, 82) Sekundärwicklungen der Transformatoren bereitstellen.

10. Quadratur-Funkempfänger-Eingangsstufe gemäß Anspruch 8 oder 9, wobei der Kondensator (76, 78) jedes LC-Speichers ein variabler Kondensator zum Einstellen der Frequenz der Quadratur-Lokaloszillator-Signale ist.

11. Quadratur-Funkempfänger-Eingangsstufe gemäß einem der Ansprüche 1 bis 6, ferner mit einem Hochfrequenzoszillator (90) und Frequenzteilern (91, 92, 93, 94) zum Bereitstellen der Lokaloszillator-Signale.

12. Quadratur-Funkempfänger-Eingangsstufe gemäß Anspruch 11, wobei die Frequenzteiler (91, 92, 93, 94) angeordnet sind zum Bereitstellen von vier Lokaloszillator-Signalen mit einem Lastzyklus von im Wesentlichen jeweils 25%, und wobei nur eines der Lokaloszillator-Signale in dem Hochzustand zu einer Zeit ist.

13. Quadratur-Funkempfänger-Eingangsstufe gemäß einem der vorhergehenden Ansprüche, ferner mit einer Stromvorrichtung (68), die mit dem Eingangsanschluss des rauscharmen Verstärker und der Erdeinrichtung verbunden ist.

14. Quadratur-Funkempfänger-Eingangsstufe gemäß Anspruch 13, wobei die Stromvorrichtung (68) ein Induktor, ein Widerstand oder ein Transistor, als eine Stromquelle verbunden, ist.

15. Verwendung einer Quadratur-Funkempfänger-Eingangsstufe gemäß einem der vorhergehenden Ansprüche in einem elektronischen Drahtlos-Kommunikationsapparat (1) zum Umwandeln eines Eingangssignals mit einer ersten Frequenz in ein Signal mit einer zweiten Frequenz.

16. Elektronischer Drahtlos-Kommunikationsapparat (1) mit einer Quadratur-Funkempfänger-Eingangsstufe gemäß einem der Ansprüche 1-14.

17. Elektronischer Drahtlos-Kommunikationsapparat gemäß Anspruch 16, wobei der elektronische Drahtlos-Kommunikationsapparat (1) ein Mobilfunkendgerät, ein Pager, ein Communicator, ein elektronischer Organizer oder ein intelligentes Telefon ist.

18. Elektronischer Drahtlos-Kommunikationsapparat gemäß Anspruch 16, wobei der elektronische Drahtlos-Kommunikationsapparat ein Mobiltelefon (1) ist.

19. Verfahren zum Unterdrücken einer Außerband-Interferenz eines Eingangssignals für eine Quadratur-Funkempfänger-Eingangsstufe und zum Umwandeln des Eingangssignals mit einer ersten Frequenz in ein Ausgangssignal mit einer zweiten Frequenz, wobei das Verfahren den Schritt zum Empfangen des Eingangssignals bei einem Eingangsanschluss der Funkempfänger-Eingangsstufe umfasst, mit den Schritten zum
Verstärken des eine Außerband-Interferenz umfassenden Eingangssignals in einem rauscharmen Verstärker (50); und
Mischen des Eingangssignals und der Außerband-Interferenz mit einem Signal mit einer zweiten Frequenz in einem ersten und einem zweiten Current-Mode-Mischer (51, 52), um ein gemischtes Signal zu erzeugen, das eine Außerband-Interferenz umfasst;
**gekennzeichnet durch**
Unterdrücken der Außerband-Interferenz des gemischten Signals **durch** Liefern des gemischten Signals an Mischerlasten, die einen parallel zu einem Kondensator (64a, 66a, 64b, 66b) geschalteten Widerstand (63a, 65a, 63b, 65b) und einen zwischen den Ausgangsanschlüssen jedes Mischers geschalteten Kondensator (67a, 67b) umfassen, wobei jede Mischerlast mit einem jeweiligen Ausgangsanschluss der Mischer (51, 52) und der Signalerdungseinrichtung verbunden ist; und **dadurch**, dass
der rauscharme Verstärker (50) wenigstens einen in einer Basisschaltungs- oder Gate-Schaltungs-Konfiguration verbundenen Transistor umfasst.

20. Verfahren gemäß Anspruch 19, wobei der Schritt zum Unterdrücken ein Unterdrücken mittels der Kondensatoren (64a, 66a, 64b, 66b, 67a, 67b) jeder Mischerlast umfasst, die Werte haben, die wirksam zum Unterdrücken der Außerband-Interferenz des gemischten Signals sind.

21. Verfahren gemäß Anspruch 20, ferner mit einem Einstellen der Kapazität des Kondensators (64a, 66a, 64b, 66b, 67a, 67b), der ein variabler Kondensator ist, jeder Mischerlast zum Unterdrücken der Außerband-Interferenz gemischter Signale unterschiedlicher empfangener Signalbandbreiten.

22. Verfahren gemäß einem der Ansprüche 19 bis 21, ferner den Schritt umfassend zum Erzeugen von Quadratur-Lokaloszillator-Signalen und Liefern der erzeugten Quadratur-Lokaloszillator-Signale an den ersten und den zweiten Mischer (51, 52), wobei die Mischer einfach symmetrische Mischer sind, zum Treiben der Mischer.

23. Verfahren gemäß Anspruch 22, ferner mit einem Einstellen der Kapazität eines Kondensators (76, 78) eines mit den Mischern (51, 52) verbundenen Quadratur-Lokaloszillators zum Einstellen der Frequenz der Quadratur-Lokaloszillator-Signale.

## Revendications

1. Circuits d'entrée d'un récepteur radio en quadrature, destinés à convertir un signal d'entrée ayant une première fréquence en un signal de sortie ayant une seconde fréquence, les circuits d'entrée du récepteur radio en quadrature comprenant une borne d'entrée, un amplificateur à faible bruit (50) ayant une borne d'entrée et une borne de sortie, un premier et un second mélangeur (51, 52), chacun ayant une borne d'entrée et une borne de sortie, et un premier et un second moyen de conversion de courant en tension (53, 54) ;
dans lequel
la borne d'entrée des circuits d'entrée du récepteur radio en quadrature est directement connectée à la borne d'entrée de l'amplificateur à faible bruit (50) ;
chaque mélangeur (51, 52) est un mélangeur en mode de courant ;
la borne de sortie du premier et du second mélangeur est connectée au premier et au second moyen de conversion de courant en tension (53, 54), respectivement ; et
chacun des moyens de conversion de courant en tension (53, 54) est une charge mélangeuse connectée à une borne de sortie respective des mélangeurs et à un moyen de mise à la masse du signal ;
**caractérisé en ce que**
l'amplificateur à faible bruit (50) comprend au moins un transistor (60) connecté en configuration à grille commune ou à base commune ;
la borne de sortie de l'amplificateur à faible bruit est directement connectée à la borne d'entrée de chaque mélangeur ; et
chaque charge mélangeuse est une résistance (63a, 65a, 63b, 65b) connectée en parallèle avec un condensateur (64a, 66a, 64b, 66b) et dans lequel un condensateur (67a, 67b) est connecté entre les bornes de sortie de chaque mélangeur.

2. Récepteur radio en quadrature selon la revendication 1, dans lequel les condensateurs (64a, 66a, 64b, 66b, 67a, 67b) de chaque mélangeur ont une valeur qui est efficace pour supprimer les interférences hors bande d'un signal appliqué aux circuits d'entrée du récepteur radio lorsque ledit signal a été mélangé.

3. Circuits d'entrée de récepteur radio en quadrature selon la revendication 2, dans lequel la capacité des condensateurs (64a, 66a, 64b, 66b, 67a, 67b) de chaque charge mélangeuse est variable pour supprimer les interférences hors bande des signaux d'entrée de différentes largeurs de bande de signal reçu.

4. Circuits d'entrée de récepteur radio en quadrature selon l'une quelconque des revendications précédentes, comprenant en outre un oscillateur local destiné à produire des signaux pour piloter le premier et le second mélangeur (61a, 62a, 61b, 62b), lesdits mélangeurs étant des mélangeurs simplement équilibrés.

5. Circuits d'entrée de récepteur radio en quadrature selon la revendication 4, dans lequel chaque mélangeur (51, 52) comprend un premier et un second transistor (61a, 62a, 61b, 62b), chaque transistor répondant à un signal en quadrature différent de l'oscillateur local.

6. Circuits d'entrée de récepteur radio en quadrature selon l'une quelconque des revendications 1 à 3, comprenant en outre un oscillateur local destiné à fournir des signaux de pilotage du premier et du second mélangeur (161a, 161b, 161c, 161d, 162a, 162b, 162c, 162d), lesdits mélangeurs étant des mélangeurs doublement équilibrés et ledit amplificateur à faible bruit étant un amplificateur différentiel (160a, 160b).

7. Circuits d'entrée de récepteur radio en quadrature selon l'une quelconque des revendications 4 à 6, dans lequel le premier et le second mélangeur (51, 52) sont connectés à un oscillateur en quadrature commandé en tension à l'aide de transformateurs (75, 77, 81, 82) afin de fournir les signaux en quadrature de l'oscillateur local sur des bornes d'entrée d'oscillateurs locaux au sein desdits premier et second mélangeurs.

8. Circuits d'entrée de récepteur radio en quadrature selon la revendication 7, dans lequel l'oscillateur commandé en tension comprend des oscillateurs en quadrature (71a, 71b, 72a, 72b, 73a, 73b, 74a, 74b) avec des circuits réservoirs LC, chaque circuit réservoir LC étant fourni par une inductance (75, 77) et un condensateur (76, 78).

9. Circuits d'entrée de récepteur radio en quadrature selon la revendication 8, dans lequel les inductances (75, 77) des circuits réservoirs LC fournissent les bobinages primaires des transformateurs et dans lequel les inductances (81, 82) connectées aux bornes d'entrée des oscillateurs locaux de chaque mélangeur (51, 52, 61a, 62a, 61b, 62b) fournissent les bobinages secondaires desdits transformateurs.

10. Circuits d'entrée de récepteur radio en quadrature selon la revendication 8 ou 9, dans lequel le condensateur (76, 78) de chaque circuit réservoir LC est un condensateur variable destiné à ajuster la fréquence des signaux en quadrature des oscillateurs locaux.

11. Circuits d'entrée de récepteur radio en quadrature selon l'une quelconque des revendications 1 à 6, comprenant en outre un oscillateur à haute fréquence (90) et des diviseurs de fréquence (91, 92, 93, 94) destinés à fournir les signaux des oscillateurs locaux.

12. Circuits d'entrée de récepteur radio en quadrature selon la revendication 11, dans lequel les diviseurs de fréquence (91, 92, 93, 94) sont agencés pour fournir quatre signaux d'oscillateurs locaux ayant chacun un rapport cyclique qui est substantiellement de 25 %, un seul desdits signaux d'oscillateurs locaux étant à l'état élevé à la fois.

13. Circuits d'entrée de récepteur radio en quadrature selon l'une quelconque des revendications précédentes, comprenant en outre un dispositif de courant (68) connecté à la borne d'entrée de l'amplificateur à faible bruit et au moyen de mise à la masse.

14. Circuits d'entrée de récepteur radio en quadrature selon la revendication 13, dans lequel le dispositif de courant (68) est une inductance, une résistance ou un transistor monté en source de courant.

15. Utilisation de circuits d'entrée de récepteur radio en quadrature selon l'une quelconque des revendications précédentes, dans un appareil de communication électronique sans fil (1), destiné à convertir un signal d'entrée ayant une première fréquence en un signal ayant une seconde fréquence.

16. Appareil de communication électronique sans fil (1) comprenant des circuits d'entrée de récepteur radio en quadrature selon l'une quelconque des revendications 1 à 14.

17. Appareil de communication électronique sans fil selon la revendication 16, dans lequel l'appareil de communication électronique sans fil (1) est un terminal radio mobile, un boîtier de recherche de personnes, un communicateur, un organiseur électronique ou un téléphone multifonctions.

18. Appareil de communication électronique sans fil selon la revendication 16, dans lequel l'appareil de communication électronique sans fil est un téléphone mobile (1).

19. Procédé de suppression des interférences hors bande d'un signal d'entrée appliqué à des circuits d'entrée d'un récepteur radio en quadrature et de conversion dudit signal d'entrée ayant une première fréquence en un signal de sortie ayant une seconde fréquence, le procédé comprenant l'étape consistant à recevoir le signal d'entrée sur la borne d'entrée des circuits d'entrée du récepteur radio et comprenant les étapes consistant à :
amplifier le signal d'entrée comprenant des interférences hors bande dans un amplificateur à faible bruit (50) ; et
mélanger le signal d'entrée et les interférences hors bande avec un signal ayant une seconde fréquence dans un premier et un second mélangeur en mode de courant (51, 52) afin de produire un signal mélangé comprenant des interférences hors bande ;
**caractérisé par** l'étape consistant à :
supprimer les interférences hors bande du signal mélangé en fournissant le signal mélangé à des charges mélangeuses composées d'une résistance (63a, 65a, 63b, 65b) montée en parallèle avec un condensateur (64a, 66a, 64b, 66b), et avec un condensateur (67a, 67b) connecté entre les bornes de sortie de chaque mélangeur, dans lequel chaque charge mélangeuse est connectée à l'une des bornes de sorties respectives des mélangeurs (51, 52) et à un moyen de mise à la terre ;
et en ce que l'amplificateur à faible bruit (50) comprend au moins un transistor connecté en configuration à grille commune ou à base commune.

20. Procédé selon la revendication 19, dans lequel l'étape de suppression comprend la suppression, à l'aide des condensateurs (64a, 66a, 64b, 66b, 67a, 67b) de chaque charge mélangeuse, qui ont des valeurs qui sont efficaces pour supprimer les interférences hors bande du signal mélangé.

21. Procédé selon la revendication 19, comprenant en outre l'ajustement de la capacité du condensateur (64a, 66a, 64b, 66b, 67a, 67b) de chaque charge mélangeuse, qui est un condensateur variable, pour supprimer les interférences hors bande des signaux d'entrée de différentes largeurs de bande de signal reçu.

22. Procédé selon l'une quelconque des revendications 19 à 21, comprenant en outre l'étape consistant à produire des signaux en quadrature d'oscillateurs locaux et à fournir, dans le but de piloter lesdits mélangeurs, lesdits signaux en quadrature produits par des oscillateurs locaux au premier et au second mélangeur (51, 52), lesdits mélangeurs étant des mélangeurs simplement équilibrés.

23. Procédé selon la revendication 22, comprenant en outre l'ajustement de la capacité d'un condensateur (76, 78) d'un oscillateur local en quadrature connecté aux mélangeurs (51, 52), afin d'ajuster la fréquence desdits signaux en quadrature des oscillateurs locaux.
